# FASCICULE DE BREVET EUROPEEN

(11) **EP 0 490 712 B1**
(45) Date de publication et mention de la délivrance du brevet: **04.09.1996**
(21) Numéro de dépôt: 91402841.0
(22) Date de dépôt: 24.10.1991
(51) Int. Cl.: H03K 17/96, H01H 13/70, H03K 17/955, H03K 17/967

(54) **Dispositif de commutation à double mode de fonctionnement**
Zweipunktschaltvorrichtung
Dual mode switching device

(30) Priorité: 13.12.1990 FR 9015597
(43) Date de publication de la demande: 17.06.1992
(73) Titulaire: SEXTANT AVIONIQUE, F-92366 Meudon la Foret Cédex (FR)
(72) Inventeur: Ferran, Patrick, F-75017 Paris (FR); Gaultier, Philippe, F-78015 Le Chesnay (FR); Vouillon, Patrick, F-91140 Villebon s/Yvette (FR)
(74) Mandataire: de Saint-Palais, Arnaud Marie

(56) Documents cités:
- EP-A- 0 054 306
- DE-A- 2 851 723
- US-A- 4 281 323

## Description

La présente invention concerne un dispositif de commutation à double mode de fonctionnement, à savoir : un premier mode de fonctionnement, de type à détection de proximité, et un deuxième mode de fonctionnement, de type à action mécanique directe.

Elle s'applique avantageusement, mais non exclusivement, à la réalisation de claviers incluant une multiplicité de dispositifs de commutation de ce genre.

D'une manière générale, on sait qu'il a déjà été proposé de nombreux types d'interrupteurs à action mécanique directe, l'une des solutions les plus simples consistant à utiliser une capsule élastique en matière électriquement conductrice, de la façon indiquée dans la demande de brevet FR No 90 04065, déposée au nom de la Demanderesse. Cette capsule élastique, en forme de calotte sphérique, est habituellement placée sur un circuit imprimé, de manière à être en contact électrique, par sa périphérie, avec une plage conductrice et s'étendre au-dessus d'une seconde plage conductrice, électriquement isolée de la première et placée sensiblement en regard de la zone centrale de la capsule.

Il est clair qu'en exerçant sur la capsule une pression orientée vers le circuit imprimé, on provoque une déformation de cette capsule jusqu'à ce que sa partie centrale vienne en butée sur la seconde plage en établissant ainsi un contact électrique entre les deux plages.

L'invention a plus particulièrement pour but d'adjoindre à un interrupteur de ce type, qui présente l'avantage d'être très plat, peu encombrant et peu coûteux, un second mode de fonctionnement de type à détection de proximité, et ce, sans en modifier la structure mécanique et donc sans en augmenter l'encombrement et l'épaisseur.

Or, les dispositifs de détection de proximité les plus simples et les moins encombrants, à savoir les détecteurs de proximité à effet capacitif, font nécessairement intervenir une plage de détection en matériau électriquement conducteur, montée sur un substrat et des moyens de connexion de cette plage à un circuit électronique. Du fait qu'elle est nécessairement disposée devant le poussoir de l'interrupteur, cette plage, de même que son substrat, sont nécessairement minces et souples. Outre le fait qu'elle accroît malgré tout l'épaisseur de l'interrupteur, cette solution présente l'inconvénient d'être peu fiable, la plage conductrice et/ou les connexions qui lui sont associées ayant tendance à se détériorer à la longue. Ces inconvénients sont considérablement amplifiés dans le cas où on désire réaliser un clavier, en raison de la multiplicité des plages, de leur connexité et du nombre important d'éléments de connexion nécessaires.

L'invention a donc plus particulièrement pour but de supprimer cet inconvénient.

Elle propose à cet effet un dispositif de commutation du type susdit faisant intervenir au moins un dispositif interrupteur comprenant au moins un élément de contact fixe porté par un substrat ainsi qu'un élément de contact mobile apte à venir s'appliquer sur l'élément de contact fixe sous l'effet d'une sollicitation.

Selon l'invention, ce dispositif est caractérisé en ce qu'au moins l'un desdits éléments de contact est en outre un élément de détection d'un dispositif de détection de proximité à effet capacitif, et en ce qu'il comprend des moyens permettant d'appliquer sur cet élément un signal électrique et des moyens aptes à détecter une variation dudit signal due à la proximité d'un objet électriquement conducteur.

Bien entendu, le circuit du dispositif de détection de proximité peut être distinct du circuit de commutation purement mécanique de l'interrupteur.

Toutefois, selon une caractéristique particulièrement avantageuse de l'invention, ces deux circuits sont combinés, le dispositif interrupteur faisant partie d'un montage capacitif local à au moins trois niveaux d'impédance, à savoir : un premier niveau d'impédance résultant de la position ouverte de l'interrupteur en l'absence de détection de présence, un deuxième niveau d'impédance correspondant à la détection d'une présence d'un élément conducteur à proximité de la capsule (augmentation de la capacité entre les deux contacts), et un troisième niveau d'impédance correspondant à la position fermée de l'interrupteur.

Un mode d'exécution de l'invention sera décrit ci-après, à titre d'exemple non limitatif, avec référence aux dessins annexés dans lesquels :
La figure 1 est une coupe transversale schématique montrant la structure mécanique d'un clavier selon l'invention ;
La figure 2 est un schéma de principe d'un circuit électronique pouvant être associé à un interrupteur du type de ceux représentés figure 1 ;
La figure 3 est un schéma électrique d'un clavier matriciel selon l'invention ;
La figure 4 est un diagramme montrant la variation en fonction du temps, de la tension prélevée sur la capsule d'un interrupteur, pour chacun des modes de fonctionnement de ce dernier ;
Les figures 5 et 6 sont deux représentions schématiques illustrant deux modes d'utilisation différents des dispositifs interrupteurs selon l'invention.

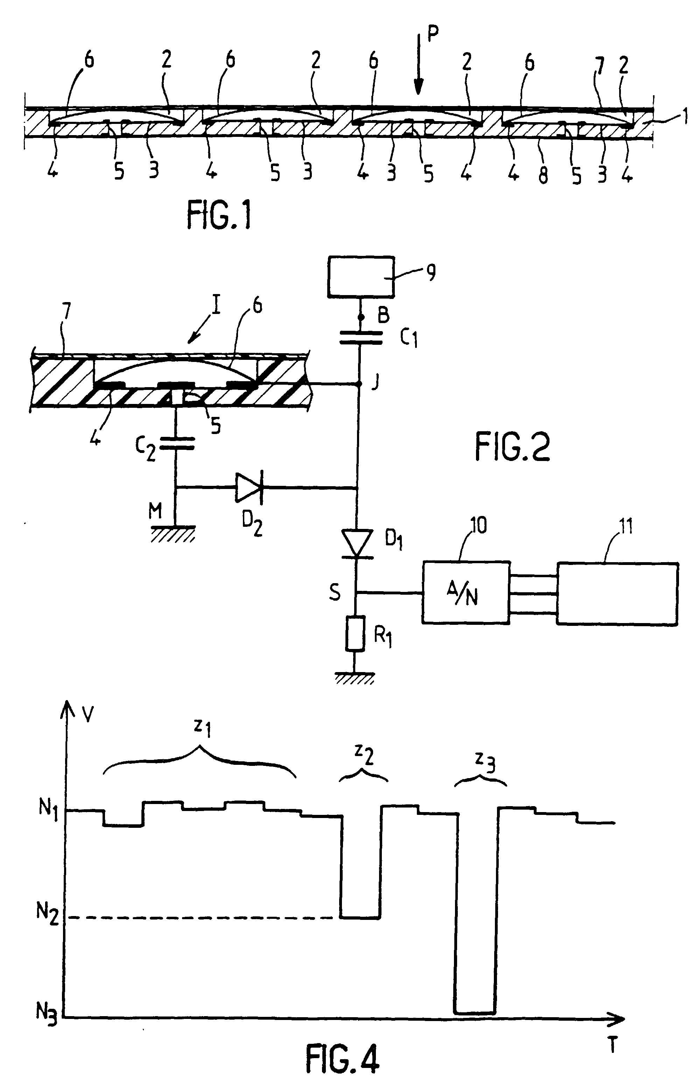

Tel que représenté sur la figure 1, le clavier se compose tout d'abord d'un substrat plat 1, consistant par exemple en une plaquette de circuit imprimé, muni d'une pluralité de cavités cylindriques 2 (lamages) servant chacune de logement à un interrupteur respectif.

Le fond 3 de chacune de ces cavités 2 est muni d'une métallisation annulaire 4 de diamètre extérieur sensiblement égal au diamètre de la cavité, ainsi que d'une métallisation centrale 5 qui sert d'élément de contact fixe.

A l'intérieur de chacune des cavités 2 est disposée une capsule métallique 6, élastiquement déformable, en forme de calotte dont la base circulaire présente un diamètre sensiblement égal au diamètre de la cavité 2. De ce fait, cette capsule 6 vient porter par sa base sur la métallisation annulaire 4, tandis que sa partie centrale s'étend au-dessus de la métallisation centrale 5.

Les capsules 6 sont maintenues à l'intérieur des évidements grâce à un film 7 en matière plastique élastiquement déformable qui vient recouvrir la face supérieure du substrat 1 et est fixé sur celle-ci, par exemple par collage.

Avantageusement, la face inférieure du substrat 1 porte un circuit électronique (non représenté) électriquement connecté aux métallisations annulaires 4 et aux métallisations centrales 5.

Il est clair qu'au repos, la partie centrale de chaque capsule 6 est écartée de la métallisation centrale 5, l'interrupteur formé par ces deux éléments étant en position ouverte.

A partir de cette position, une pression P exercée sur le sommet de la capsule 6 va provoquer une déformation élastique de la capsule 6 qui, après une inversion de concavité (effet tactile vient porter sur la métallisation centrale 5. L'interrupteur est alors à l'état fermé.

A ce premier mode de fonctionnement des interrupteurs du clavier, l'invention propose de rajouter un second mode de fonctionnement, de type à détection de proximité.

Dans l'exemple représenté sur la figure 2, ce résultat est obtenu :
- d'une part, en associant localement, à chacun des interrupteurs I, un montage capacitif comprennant, en série entre une borne B sur laquelle est appliqué un signal périodique haute fréquence émis par un générateur 9, et un potentiel de référence (masse M), un premier condensateur C₁, l'interrupteur I et un deuxième condensateur C2 présentant une capacité relativement élevée, le point de jonction J entre le premier condensateur C₁ et l'interrupteur I étant relié à la masse par l'intermédiaire d'une diode D₁ et d'une résistance R₁ ; et
- d'autre part, en détectant le niveau de tension présent au point de sortie S (jonction entre la diode D₁ et la résistance R₁).

Il s'avère en effet que lorsque l'interrupteur I est à l'état ouvert et en l'absence d'élément conducteur à proximité de la capsule 6, le signal appliqué à la borne B est redressé et filtré. On obtient en S un signal à un premier niveau de tension N₁.

La présence d'un corps électriquement conducteur à proximité de la capsule 6 a pour effet d'introduire une capacité parasite entre le point S et la masse. En conséquence, il s'établit un courant de fuite qui atténue le signal de tension prélevé au point de jonction J. Le signal de sortie en S a donc une tension située à un deuxième niveau N₂, bien inférieur au premier.

Dans le cas où l'interrupteur I est fermé, le point de jonction J se trouve relié à la masse par l'intermédiaire du condensateur C₂. Ainsi, à condition de prévoir un condensateur C₂ de capacité suffisamment élevée, on obtient au point de sortie S un signal de tension de valeur très faible, voire même nulle (niveau N₃).

Bien entendu, le signal de tension prélevé au point S peut être analysé par un système analogique (qui procède par exemple par comparaison avec des tensions de seuils) de manière à discerner les trois niveaux et, en conséquence, sélecter les commandes qui leurs correspondent. Il peut être tout simplement appliqué à un convertisseur analogique 10 suivi d'un circuit d'utilisation 11.

Cette solution est particulièrement avantageuse dans le cas où l'on souhaite réaliser un clavier de type matriciel.

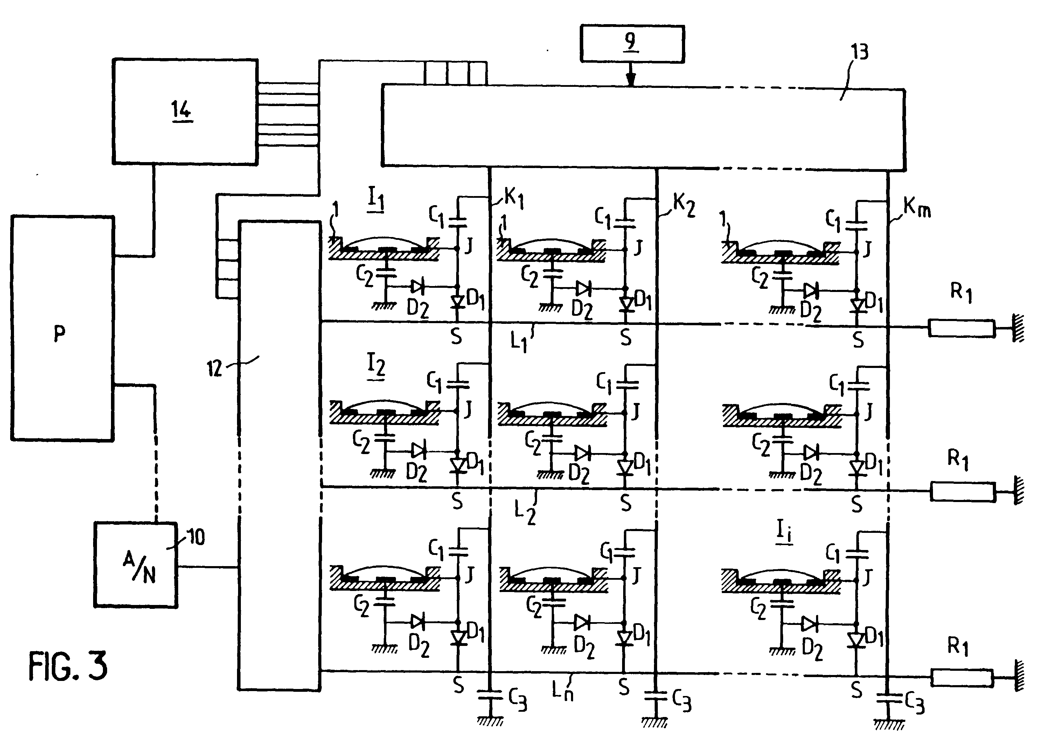

En effet, dans ce cas, ce clavier peut comprendre, comme représenté figure 3 :
- une première succession de conducteurs parallèles définissant une suite de lignes L₁, L₂ ..., Lₙ, ces conducteurs pouvant être déposés sur l'une des deux faces de la plaquette de circuit imprimé utilisée comme substrat 1 du clavier ;
- une deuxième succession de conducteurs parallèles définissant une suite de colonnes K₁, K₂ ..., Kₘ axées perpendiculairement auxdites lignes L₁, L₂ ..., Lₙ, ces conducteurs pouvant être déposés sur la deuxième face de la plaquette de circuit imprimé ;
- des dispositifs interrupteurs Iₗ à Iᵢ du type de ceux représentés figures 1 et 2 respectivement placés aux voisinages des intersections entre les lignes et les colonnes.

Chacune des lignes L₁, L₂ ..., Lₙ est connectée, d'une part, d'un côté, à une entrée correspondante d'un multiplexeur 12 et, d'autre part, de l'autre côté, à la masse, par l'intermédiaire d'une résistance R₁.

Chacune des colonnes est connectée, d'une part, à une sortie d'un décodeur 13 qui permet d'appliquer successivement sur les colonnes K₁, K₂ ..., Kₘ, un signal périodique haute fréquence (signal carré de 2 MHz) provenant d'un générateur 9, et, d'autre part, à la masse par l'intermédiaire d'un condensateur de capacité relativement faible C₃.

Le dispositif de commutation 13, ainsi que le multiplexeur 12 sont pilotés par un même compteur 14 de manière à pouvoir assurer une scrutation du clavier selon une séquence classique.

La sortie du multiplexeur 12 est appliquée à l'entrée d'un convertisseur analogique-numérique 10 lui-même connecté à un processeur P.

A chaque dispositif interrupteur I₁ à Iᵢ est associé localement un montage capacitif du type de celui représenté sur la figure 2.

Ce montage comprend plus particulièrement un circuit reliant la colonne K à la masse et comportant, en série, un premier condensateur C₁, le dispositif interrupteur I et un deuxième condensateur C₂.

Le point de jonction J entre le condensateur C₁ et le dispositif interrupteur est relié à une ligne L₁, L₂ ..., Lₙ, par l'intermédiaire d'une diode D₁ montée en direct et à la masse, par l'intermédiaire d'une diode D₂ montée en inverse.

Le fonctionnement de ce circuit capacitif est le même que celui qui a été décrit en regard de la figure 2 et ne sera donc pas exposé à nouveau.

Par contre, au niveau du clavier, le cycle de scrutation est le suivant :

Au cours d'une première période, le dispositif de commutation 13 va appliquer sur la première colonne K₁ le signal haute fréquence émis par la source 9. Au cours de cette première période, le multiplexeur 12 va successivement connecter les lignes L₁, L₂ ..., Lₙ à la sortie.

Au cours d'une seconde période, le signal haute fréquence est appliqué à la deuxième colonne K₂ et le multiplexeur 12 effectue à nouveau sa séquence de connexions.

Ce processus se répète jusqu'à la m^{ième} colonne Kₘ. Le système a fini le cycle de scrutation et peut alors entamer un nouveau cycle.

Il est clair que selon ce type de scrutation, à chaque instant, le processeur détecte l'état (niveau de tension au point S) d'un ensemble interrupteur/circuit capacitif, dont il connaît l'adresse.

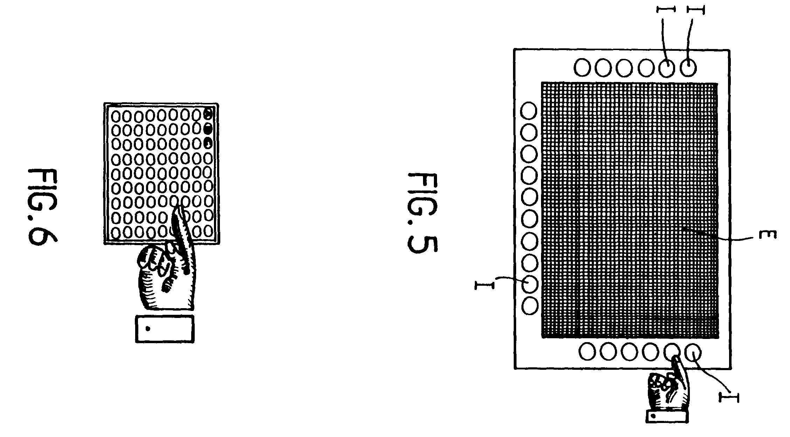

Dans le cas où cet ensemble n'est pas sollicité ou influencé par la proximité d'un objet électriquement conducteur, la tension fournie à la sortie du multiplexeur présentera une valeur maximum (niveau N₁). Comme cela se trouve illustré sur le diagramme de la figure 4, cette valeur maximale fluctue légèrement d'un ensemble à l'autre (zone z₁), les résistances R₁ et les capacités C₃ servant notamment à ajuster ces tensions aussi près que possible de la valeur que l'on s'est fixée.

Dans le cas où un ensemble est influencé par la présence d'un objet électriquement conducteur en raison du courant parasite engendré par l'augmentation de la capacité capsule 6/contact fixe 5 du dispositif interrupteur I, la tension recueillie à la sortie du multiplexeur 12 présentera une valeur intermédiaire nettement inférieure à la valeur maximum (niveau N₂), (zone z₂, figure 4).

Dans le cas où le dispositif interrupteur I est en position fermée, la tension présente à la sortie du multiplexeur 12 sera minimale, voire même nulle (niveau N₃), (zone z₃, figure 4).

Grâce à son double mode de fonctionnement, le dispositif interrupteur selon l'invention peut être utilisé dans de multiples applications.

Ainsi, par exemple, la figure 5 illustre une application selon laquelle des dispositifs interrupteurs I sont placés sur le bord d'un écran E et assurent simultanément les fonctions de clé de ligne et de surface tactile. Le déplacement du doigt le long de cette surface tactile permet, par exemple de dérouler un menu, d'assurer une fonction "ascenseur" pour se déplacer dans une image ou un texte plus grand que l'écran, d'incrémenter ou de décrémenter une valeur numérique, de déplacer un curseur et/ou d'effectuer une validation.

La figure 6 montre un clavier matriciel du type de celui précédemment décrit qui, grâce aux dispositions précédemment décrites, a la particularité de pouvoir, dans le même encombrement, assurer les fonctions d'un clavier classique et d'une tablette tactile.

Dans ce dernier type d'application, le processeur associé au clavier pourra avantageusement calculer le barycentre des dispositifs interrupteurs qui se trouvent influencés, au même moment, par exemple, en raison de la proximité d'un doigt d'un opérateur.

Un tel traitement, qui se trouve décrit dans les demandes de brevet FR No 87 07323 et FR No 90 06820, permet d'obtenir une résolution très supérieure à la résolution d'un clavier à détection de proximité de type classique.

## Revendications

1. Dispositif de commutation à double mode de fonctionnement, à savoir : un premier mode de fonctionnement, de type à détection de proximité et un deuxième mode de fonctionnement, de type à action mécanique directe, ce dispositif de commutation faisant intervenir au moins un dispositif interrupteur comprenant au moins un élément de contact fixe (4, 5) porté par un substrat (1) ainsi qu'un élément de contact mobile (6) apte à venir s'appliquer sur l'élément de contact fixe (4, 5) sous l'effet d'une sollicitation,
caractérisé en ce qu'au moins l'un desdits éléments de contact (4, 5, 6) est en outre un élément de détection d'un dispositif de détection de proximité à effet capacitif, et en ce qu'il comprend des moyens (9) permettant d'appliquer sur cet élément un signal électrique et des moyens (10, 11) aptes à détecter une variation dudit signal due à la proximité d'un objet électriquement conducteur.

2. Dispositif selon la revendication 1,
caractérisé en ce que le dispositif interrupteur comprend deux éléments de contacts fixes consistant en deux plages conductrices portées par le substrat et un pont de contact mobile qui est en contact électrique avec l'une des deux plages (4) et s'étend au repos au-dessus de la deuxième plage (5), ledit pont de contact mobile servant d'élément de détection du susdit dispositif de détection.

3. Dispositif selon la revendication 1,
caractérisé en ce que le susdit pont de contact mobile consiste en une capsule élastique (6).

4. Dispositif selon l'une des revendications précédentes,
caractérisé en ce que le dispositif de détection de proximité est indépendant du circuit de commutation purement mécanique (4, 5, 6) du dispositif interrupteur.

5. Dispositif selon l'une des revendications 1 à 3,
caractérisé en ce que le dispositif interrupteur fait partie d'un montage capacitif (C₁, C₂) à au moins trois niveaux d'impédance, à savoir :
- un premier niveau d'impédance résultant de la position ouverte du dispositif interrupteur (I) en l'absence d'une détection de présence ;
- un deuxième niveau d'impédance résultant d'une détection de présence, le dispositif interrupteur (I) étant en position ouverte ; et
- un troisième niveau d'impédance résultant de la position fermée du dispositif interrupteur (I).

6. Dispositif selon la revendication 5,
caractérisé en ce que le susdit montage capacitif comprend, d'une part, en série, entre une borne (B) sur laquelle est appliqué un signai périodique haute fréquence émis par un générateur (9) et une borne (M) portée à un potentiel de référence, un premier condensateur (C₁), le dispositif interrupteur (I) et un deuxième condensateur (C₂), le point de jonction (J) entre le premier condensateur (C₁) et le dispositif interrupteur (I), étant relié au potentiel de référence, par l'intermédiaire d'une diode et d'une résistance et, d'autre part, des moyens de détection permettant de détecter la tension au point de sortie (S).

7. Dispositif selon la revendication 6,
caractérisé en ce qu'il comprend des moyens (10) permettant d'effectuer l'analyse de la tension prélevée au susdit point de sortie (S).

8. Dispositif selon la revendication 7,
caractérisé en ce que lesdits moyens d'analyse sont analogiques.

9. Dispositif selon la revendication 7,
caractérisé en ce que les moyens d'analyse comprennent un convertisseur analogique/numérique (10) couplé à un processeur (P).

10. Dispositif selon la revendication 1, dans lequel les dispositifs interrupteurs sont agencés selon une configuration matricielle,
caractérisé en ce qu'il comprend :
- une première succession de conducteurs parallèles définissant une suite de lignes (L₁, L₂ ..., Lₙ), chacune de ces lignes étant connectée par l'une de ses extrémités à une entrée correspondante d'un multiplexeur (12) ;
- une deuxième succession de conducteurs parallèles définissant une suite de colonnes (K₁, K₂ ..., Kₘ) axées perpendiculairement auxdites lignes, chacune de ces colonnes étant connectée à une sortie d'un dispositif de commutation (13) apte à appliquer successivement sur lesdites colonnes, un signal périodique haute fréquence ;
- à chaque intersection ligne/colonne (L, K), un dispositif interrupteur (Iₗ ..., Iᵢ) associé à un montage capacitif comprenant, en série, entre la colonne (K) et un potentiel de référence, un premier condensateur (C₁), le dispositif interrupteur (I) et un deuxième condensateur (C₂), le point de jonction (J) entre le premier condensateur (C₁) et le dispositif interrupteur étant relié à la ligne (L) par l'intermédiaire d'une diode (D₁).

## Patentansprüche

1. Umschaltvorrichtung mit doppeltem Betriebsmodus, d.h. einem ersten Betriebsmodus der Art mit Nähenerfassung und einem zweiten Betriebsmodus der Art mit direkter mechanischer Wirkung, wobei diese Umschaltvorrichtung mindestens eine Schaltvorrichtung verwendet, die mindestens ein auf einem Substrat (1) angeordnetes festes Kontaktelement (4, 5) sowie ein bewegliches Kontaktelement (6) aufweist, das sich unter der Wirkung einer Beanspruchung auf das feste Kontaktelement (4, 5) auflegen kann,
dadurch gekennzeichnet, daß mindestens eines der Kontaktelemente (4, 5, 6) außerdem ein Erfassungselement einer Nähenerfassungsvorrichtung mit kapazitiver Wirkung ist, und daß sie Mittel (9), die es ermöglichen, an dieses Element ein elektrisches Signal anzulegen, und Mittel (10, 11) aufweist, die eine Veränderung dieses Signals aufgrund der Nähe eines elektrisch leitenden Gegenstands erfassen können.

2. Vorrichtung nach Anspruch 1, dadurch gekennzeichnet, daß die Schaltvorrichtung zwei feste Kontaktelemente, die aus zwei auf dem Substrat liegenden leitenden Bereichen bestehen, und eine beweglichen Kontaktbrücke aufweist, die mit einem der beiden Bereiche (4) in elektrischem Kontakt steht und sich in der Ruhestellung oberhalb des zweiten Bereichs (5) erstreckt, wobei die bewegliche Kontaktbrücke als Erfassungselement der Erfassungsvorrichtung dient.

3. Vorrichtung nach Anspruch 1, dadurch gekennzeichnet, daß die bewegliche Kontaktbrücke aus einer elastischen Kapsel (6) besteht.

4. Vorrichtung nach einem der vorhergehenden Ansprüche, dadurch gekennzeichnet, daß die Nähenerfassungsvorrichtung vom rein mechanischen Schaltkreis (4, 5, 6) der Schaltvorrichtung unabhängig ist.

5. Vorrichtung nach einem der Ansprüche 1 bis 3, dadurch gekennzeichnet, daß die Schaltvorrichtung Teil einer kapazitiven Schaltung (C₁, C₂) mit mindestens drei Impedanzpegeln ist, d.h.:
- einem ersten Impedanzpegel, der aus der offenen Stellung der Schaltvorrichtung (I) in Abwesenheit einer Nähenerfassung hervorgeht;
- einem zweiten Impedanzpegel, der aus einer Nähenerfassung hervorgeht, wobei die Schaltvorrichtung (I) in der offenen Stellung ist; und
- einem dritten Impedanzpegel, der aus der geschlossenen Stellung der Schaltvorrichtung (i) hervorgeht.

6. Vorrichtung nach Anspruch 5, dadurch gekennzeichnet, daß die obige kapazitive Schaltung einerseits in Reihe zwischen einer Klemme (B), an die ein von einem Generator (9) gesendetes periodisches Hochfrequenzsignal angelegt wird, und einer Klemme (M), die auf ein Bezugspotential gebracht wird, einen ersten Kondensator (C₁), die Schaltvorrichtung (I) und einen zweiten Kondensator (C₂) aufweist, wobei der Verbindungspunkt (J) zwischen dem ersten Kondensator (C₁) und der Schaltvorrichtung (I) über eine Diode und einen Widerstand mit dem Bezugspotential verbunden ist, und andererseits Erfassungsmittel enthält, die es ermöglichen, die Spannung am Ausgangspunkt (S) zu erfassen.

7. Vorrichtung nach Anspruch 6, dadurch gekennzeichnet, daß sie Mittel (10) aufweist, um die Analyse der am Ausgangspunkt (S) erfaßten Spannung durchzuführen.

8. Vorrichtung nach Anspruch 7, dadurch gekennzeichnet, daß die Analysemittel analoge Mittel sind.

9. Vorrichtung nach Anspruch 7, dadurch gekennzeichnet, daß die Analysemittel einen Analog-Digital-Wandler (10) aufweisen, der mit einem Prozessor (P) gekoppelt ist.

10. Vorrichtung nach Anspruch 1, bei der die Schaltvorrichtungen matrixartig angeordnet sind,
dadurch gekennzeichnet, daß sie aufweist:
- eine erste Folge von parallelen Leitern, die eine Folge von Zeilen (L₁, L₂, ... Lₙ) bilden, wobei jede dieser Zeilen mit einem ihrer Enden an einen entsprechenden Eingang eines Multiplexers (12) angeschlossen ist;
- eine zweite Folge von parallelen Leitern, die eine Folge von Spalten (K₁, K₂, ... K₂) bilden, deren Achse senkrecht zu denen der Zeilen liegt, wobei jede dieser Spalten mit einem Ausgang einer Umschaltvorrichtung (13) verbunden ist, die nacheinander an die Spalten ein periodisches Hochfrequenzsignal anlegen kann;
- an jeder Schnittstelle Zeile/Spalte (L, K) eine Schaltvorrichtung (Iₗ, ..., Iᵢ), die einer kapazitiven Schaltung zugeordnet ist, die in Reihe zwischen der Spalte (K) und einem Bezugspotential einen ersten Kondensator (C₁), die Schaltvorrichtung (I) und einen zweiten Kondensator (C₂) aufweist, wobei der Verbindungspunkt (J) zwischen dem ersten Kondensator (C₁) und der Schaltvorrichtung über eine Diode (D₁) mit der Zeile (L) verbunden ist.

## Claims

1. Switch device with two operating modes, namely : a proximity sensing first operating mode and a direct mechanical action second operating mode, said device comprising at least one switch comprising at least one fixed contact member (4, 5) carried by a substrate (1), and a mobile contact member (6) adapted to be urged into contact with said fixed contact member (4, 5),
characterized in that at least one of said contact members (4, 5, 6) is additionally a sensing element of a capacitive proximity sensing device, and in that it comprises means (9) for applying to said element an electrical signal, and means (10, 11) for sensing variations in said signal due to the proximity of an electrically conductive object.

2. Device according to claim 1,
characterized in that said switch comprises two fixed contact members in the form of two conductive areas carried by said substrate and a mobile contact bridge which is in electrical contact with one of said two areas (4) and in the unoperated condition overlies the second area (5), said mobile contact bridge functioning also as the sensing element of said sensing device.

3. Device according to claim 1,
characterized in that said mobile contact bridge is an elastic capsule (6).

4. Device according to one of the preceding claims,
characterized in that said proximity sensing device is independent of the purely mechanical switching circuit (4, 5, 6) of said switch device.

5. Device according to one of claims 1 to 3,
characterized in that said switch device is part of a capacitive circuit (C₁, C₂) having at least three levels of impedance, namely :
- a first level of impedance resulting from the open position of said switch device (I) in the absence of proximity sensing ;
- a second level of impedance resulting from the open position of said switch device (I) in the presence of proximity sensing ; and
- a third level of impedance resulting from the closed position of said switch device (I).

6. Device according to claim 5,
characterized in that said capacitive circuit comprises on the one hand, connected in series between a terminal (B) to which a high-frequency periodic signal is applied by a generator (9) and a terminal (M) adapted to be held at a reference potential, a first capacitor (C₁), said switch device (I), and a second capacitor (C₂), the point (J) at which said first capacitor (C₁) is connected to said switch device (I) being connected to said reference potential by a diode and a resistor and, on the other hand, sensing means adapted to sense a voltage at the output point (S).

7. Device according to claim 6,
characterized in that it comprises means (10) for analyzing the voltage at said output point (S).

8. Device according to claim 7,
characterized in that said analyzer means are analog analyzer means.

9. Device according to claim 7,
characterized in that said analyzer means comprise an analog/digital converter (10) connected to a processor (P).

10. Device according to claim 1, in which said switches are laid out in a matrix configuration,
characterized in that it comprises :
- a first succession of parallel conductors defining a series of rows (L₁, L₂, ... Lₙ) each connected at one end to a respective input of a multiplexer (12),
- a second succession of parallel conductors defining a series of columns (K₁, K₂, ... Kₘ) perpendicular to said rows, each connected to an output of a switch unit (13) adapted to apply successively to said columns a high-frequency periodic signal,
- at each row/column intersection (L, K) a switch device (I₁ ...Iᵢ) associated with a capacitive circuit comprising connected in series between the column ( K) and a reference potential, a first capacitor (C₁), said switch device (I), and a second capacitor (C₂), the point (J) at which said first capacitor (C₁) is connected to said switch device being connected to said line (L) by a diode (D₁).
